# FASCICULE DE BREVET EUROPEEN

(11) **EP 2 337 042 B1**
(45) Date de publication et mention de la délivrance du brevet: **26.09.2012**
(21) Numéro de dépôt: 10194075.7
(22) Date de dépôt: 08.12.2010
(51) Int. Cl.: H01H 1/00

(54) **Composant RF comprenant un commutateur à base de nanotubes**
RF-Bauteil mit einem Schalter basierend auf Kohlenstoff-Nanoröhren
RF component comprising a switch based on carbon nanotubes

(30) Priorité: 15.12.2009 FR 0906065
(43) Date de publication de la demande: 22.06.2011
(73) Titulaire: Thales, 92200 Neuilly Sur Seine (FR)
(72) Inventeur: Ziaei, Afshin, 92170, Vanves (FR); Charles, Michaël, 77200, Torcy (FR)
(74) Mandataire: Esselin, Sophie

(56) Documents cités:
- EP-A2- 1 087 413
- US-A1- 2007 051 970
- DRAGOMAN M ET AL: "Nanoelectromechanical switches based on carbon nanotubes for microwave and millimeter waves", APPLIED PHYSICS LETTERS, AIP, AMERICAN INSTITUTE OF PHYSICS, MELVILLE, NY, US LNKD- DOI:10.1063/1.2712774, vol. 90, no. 11, 12 mars 2007 (2007-03-12) , pages 113102-113102, XP012093603, ISSN: 0003-6951
- DEMOUSTIER ET AL: "Review of two microwave applications of carbon nanotubes: nano-antennas and nano-switches", COMPTES RENDUS - PHYSIQUE, ELSEVIER, PARIS, FR LNKD- DOI:10.1016/J.CRHY.2008.01.001, vol. 9, no. 1, 14 février 2008 (2008-02-14), pages 53-66, XP022524307, ISSN: 1631-0705
- A. ZIAEI, S. DEMOUSTIER, E. MINOUX: "Micro- & Nano-technologies pour applications hyperfréquence à Thales Research & Technology", , 20 mars 2007 (2007-03-20), XP002592361, Extrait de l'Internet: URL:http://ursi-france.institut-telecom.fr /pages/pages_evenements/journees_scient/do cs_journees_2007/1.1%20-%20DEMOUSTIER_JS07 .pdf [extrait le 2010-07-16]

## Description

Le domaine de l'invention est celui des composants RF comprenant des structures de commutateurs de très faibles dimensions de type nanométriques encore appelés NEMS RF (Nano-Electro-Mechanical System) capacitif et ohmique et possédant des propriétés hyperfréquences comparables à celles des MEMS (Micro-Electro-Mechanical system) hyperfréquence. De tels composants très miniaturisés sont particulièrement recherchés dans des domaines aussi variés que les secteurs de l'industrie de l'armement (satellites, systèmes embarqués, etc...), les secteurs de la téléphonie mobile, des écrans plats, ou encore le secteur médical (sondes, ...).

Actuellement, il a déjà été proposé des micro-commutateurs pour lignes RF. Il existe ainsi des micro-commutateurs comportant des structures de membrane déformables sous l'action d'un champ électrostatique. Plus précisément, ces micro-commutateurs comprennent une membrane ou une poutre métallique de faible épaisseur, maintenue suspendue par des supports au-dessus de surfaces conductrices isolées entre elles.

Dans le cadre de la commutation, l'ensemble membrane - surface conductrice peut être soumis à une différence de potentiel. En l'absence de différence de potentiel appliquée, la membrane est suspendue au-dessus des surfaces conductrices et il n'y a aucun contact électrique entre celles-ci.

En général, on n'utilise pas les micro-commutateurs MEMS radiofréquence ou hyperfréquence en interrupteur simple. En effet, le contact ohmique direct entre la membrane et les surfaces conductrices ou l'électrode de commande diminue notablement la durée de vie du dispositif. On interpose entre les surfaces conductrices et la membrane, une couche de diélectrique. On transforme ainsi le contact ohmique en contact capacitif dont les armatures de la capacité sont constituées d'une part de la surface de contact de la membrane et d'autre part de la surface de contact au niveau de la surface conductrice pouvant correspondre à une ligne RF. La capacité varie alors d'une valeur Cᵤₚ à une valeur C_{down}.

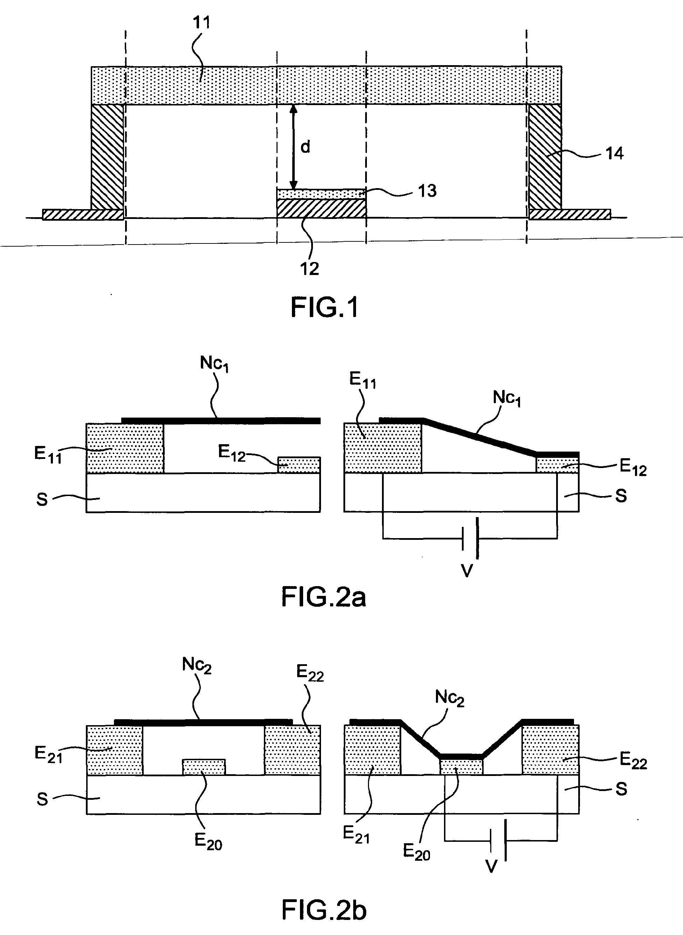

Dans la position initiale, la membrane 11 se trouve à une distance vide d plus épaisseur de diélectrique, par rapport à une ligne RF 12, sur laquelle une couche de diélectrique par exemple de nitrure 13 est déposée comme illustré en figure 1. Les deux extrémités de la membrane sont à la masse 14.

Si on applique progressivement une différence de potentiel V entre la ligne RF et la membrane, la membrane défléchie diminuant la distance entre la membrane et le diélectrique de nitrure. A une valeur V de la tension, la membrane s'effondre sur la couche de diélectrique. Le switch est dit en position basse et cette valeur de tension est dénommée tension d'activation. Quand la membrane est en position haute, le signal RF passe dans la ligne RF sans être perturbé.

Quand la membrane est en position basse, le signal RF est court-circuité et passe de la ligne RF aux plans de masse par la membrane ce qui crée une réflexion de l'onde EM (signal hyperfréquence), le signal ne traverse pas le switch MEMS RF.

La présente invention propose de remplacer ce type de micro-commutateurs par des nano-structures de dimensions encore plus faibles. Pour ce faire, il est proposé d'utiliser des structures NEMS à base de géométries cylindriques nanométriques pouvant être des nanotubes de carbone ou des nanofils.

Il est connu de l'article de DRAGOMAN M ET AL. « Nanoelectromechanical switches based on carbon nanotubes for microwave and millimeter waves » APPLIED PHYSICS LETTERS, vol.90,12 mars 2007 (2007-03-12), pages 113102, XP12093603, un composant RF comprenant au moins une ligne RF coplanaire avec une surface métallique à la surface d'un substrat recouvert au moins partiellement d'une couche diélectrique et une structure de commutateur située entre ladite ligne coplanaire et la surface métallique. Le composant comprend une première série de nanotubes ou nanofils localisés verticalement à la surface de la ligne RF et une seconde série de nanotubes ou nanofils localisés verticalement à la surface de ladite surface métallique pour permettre une activation de la structure de nano-commutateur ainsi réalisée.

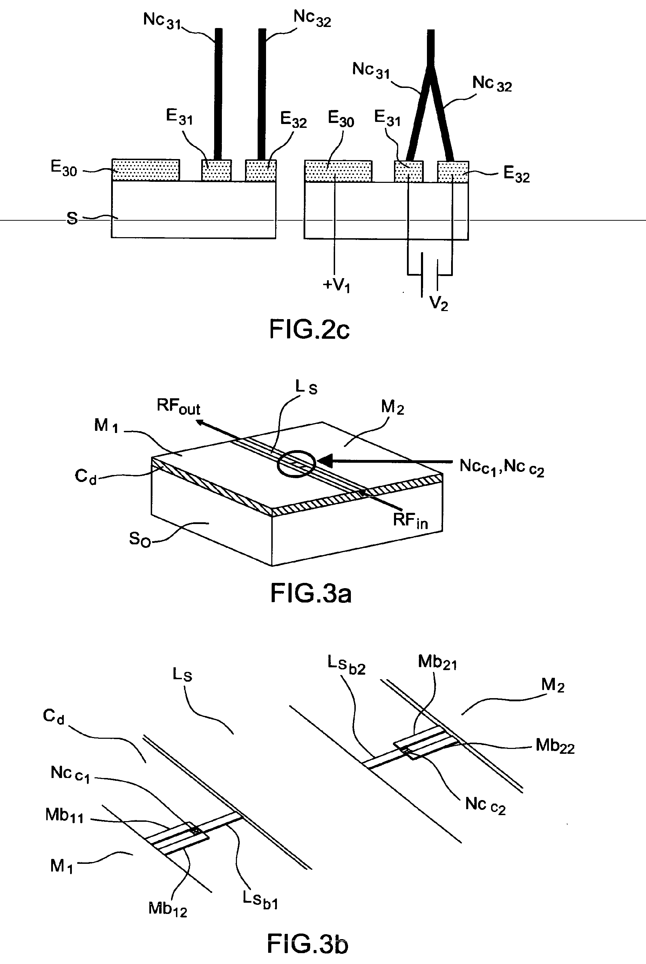

De telles structures ont déjà été décrites en tant que commutateur mécanique simple et ce en mettant en relief différentes configurations, telles que des poutres, des ponts ou des pinces et tels que représentés respectivement en figures 2a, 2b et 2c, au repos et soumises à une différence de potentiel.

Plus précisément dans le cas de la poutre illustrée en figure 2a, deux surfaces métalliques E₁₁ et E₁₂ sont déposées à la surface d'un substrat S. Un dépôt de nanotube Nc₁ est réalisé sur la surface E₁₁. Sous l'action d'une différence de potentiel V appliquée entre les deux surfaces E₁₁ et E₁₂, le(s) nanotube(s) connecte(nt) les deux surfaces E₁₁et E₁₂.

Dans le cas de la structure de pont illustrée en figure 2b, trois surfaces métalliques E₂₀, E₂₁ et E₂₂ sont déposées à la surface d'un substrat -S, les surfaces E₂₁ et E₂₂ étant reliées entre elle par un ou plusieurs nanotubes Nc₂. On réalise le dépôt de nanotube(s) sur les surfaces E₂₁ et E₂₂. Lorsqu'une différence de potentiel V est appliquée entre la surface E₂₀ et une surface E₂₂ par exemple, le(s) nanotube(s) est(sont) amené(s) en contact avec la surface E₂₀.

Dans le cas de la structure dite de pince illustrée en figure 2c, un premier nanotube Nc₃₁ est situé sur la surface E₃₁, un autre nanotube Nc₃₂ étant situé sur la surface E₃₂. La commutation est réalisée grâce à la présence de deux tensions V₁ (pouvant être au moins de l'ordre de quelques dizaines de volts) et V₂ (inférieure à 1 Volt) respectivement appliquée sur la surface E₃₀ et entre les surfaces E₃₁ et E₃₂.

De tels nano-commutateurs n'ont à ce jour pas été intégrés dans des composants hyperfréquence, pour réaliser notamment des fonctions de commutation permettant de basculer un signal passant dans une ligne RF à un état non passant, de très petites dimensions, ouvrant par la même la voie à un degré d'intégration très élevé.

C'est pourquoi l'objet de la présente invention réside dans une solution intégrant une adaptation de ligne RF coplanaire connectée à des lignes de masse via de tels nano-commutateurs fonctionnant comme des pinces telles que celles illustrées en figure 2c.

La présente invention propose ainsi une nouvelle structure nanométrique possédant des propriétés hyperfréquence comparable au MEMS (Micro-Electro-Mechanical system) hyperfréquence, en exploitant les propriétés exceptionnelles des nanotubes de carbone ou nanofils tant sur le plan mécanique que sur le plan électrique.

Plus précisément la présente invention a pour objet un composant RF comprenant au moins une ligne RF (Ls) coplanaire avec une surface métallique (M₁,M₂) à la surface d'un substrat (S₀) recouvert au moins partiellement d'une couche diélectrique (Cd) et une structure de commutateur située entre ladite ligne coplanaire et la surface métallique comprenant une première série de nanotubes ou nanofils (Nc_{Ls}) localisés verticalement à la surface de la ligne RF, une seconde série de nanotubes ou nanofils localisés (Nc_{M1}, N_{CM2}) verticalement à la surface de ladite surface métallique permettant une activation de la structure de nano-commutateur (NC_{c1}, NC_{c2}) à contact nanotubes-nanotubes ou nanofils-nanofils entre ladite ligne RF et la surface métallique (M₁,M₂) par application d'une faible différence de potentiel entre la ligne RF et ladite surface métallique, caractérisé en ce qu'il comprend en outre une troisième série de nanotubes ou de nanofils (NC_{ca1}, Nc_{ca2}) localisée verticalement au niveau d'au moins une cavité (Cₐ₁, Cₐ₂, Cₐ₁₁, Cₐ₁₂, Cₐ₂₁, Cₐ₂₂) réalisée dans la couche de diélectrique et en contact avec la surface du substrat, ladite cavité étant située entre la ligne RF et ladite surface métallique, ladite activation se faisant aussi avec une polarisation dudit substrat par une tension de polarisation.

Ce type de nano-structure permet d'envisager de réaliser dans un très faible encombrement, la mise en parallèle d'une grande quantité de commutateurs à base de nanotubes ou nanofils en configuration pince, afin d'assurer la circulation d'un signal hyperfréquence.

Selon une variante de l'invention, la faible différence de potentiel est inférieure à environ 1 Volt, la tension de polarisation du substrat étant supérieure à au moins une dizaine de volts.

Selon une variante de l'invention, la ligne RF est située entre deux surfaces métalliques constitutives de plans de masse.

Selon une variante de l'invention, la ligne RF et la ou les surfaces métalliques sont parallèles entre elles selon une première direction, et comprennent des éléments latéraux perpendiculaires à ladite première direction et coopérant entre eux par l'intermédiaire des séries de nanotubes ou nanofils.

Selon une variante de l'invention, les éléments latéraux de la ligne RF présentent chacun, une ouverture positionnée en regard d'une cavité dans laquelle est située la troisième série de nanotubes ou de nanofils.

Selon une variante de l'invention, la seconde série de nanotubes comprend des nanotubes ou des nanofils enrobés de matériau diélectrique.

Selon une variante de l'invention, la première série de nanotubes ou de nanofils comprend des nanotubes ou des nanofils enrobés de matériau diélectrique, le substrat étant polarisé en périphérie pour faire basculer les nanotubes ou nanofils adjacents.

Selon une variante de l'invention, au moins une série de nanotubes est enrobée d'une couche de métal.

Selon une variante de l'invention, les dimensions des cavités sont de l'ordre de quelques micromètres.

Selon une variante de l'invention, la distance entre la ligne signal et les plans de masse est comprise entre environ 10 et 100 microns.

Selon une variante de l'invention, les cavités sont parallélépipédiques.

L'invention sera mieux comprise et d'autres avantages apparaîtront à la lecture de la description qui va suivre donnée à titre non limitatif et grâce aux figures annexées parmi lesquelles :
- la figure 1 illustre un exemple de micro-commutateur de ligne RF selon l'art connu ;
- les figures 2a, 2b et 2c illustrent des exemples de commutateur mécanique de l'art connu respectivement de type poutre, pont et pince ;
- les figures 3a à 3d illustrent différentes vues d'un exemple de composant RF selon l'invention ;
- les figures 4a à 4e illustrent une première variante de nano-commutateurs intégrés dans un composant RF de l'invention ;
- les figures 5a et 5b illustrent une seconde variante de nano-commutateurs intégrés dans un composant RF de l'invention ;
- les figures 6a et 6b illustrent une troisième variante de nano-commutateurs intégrés dans un composant RF de l'invention, respectivement sans différence de tension appliquée et avec différence de tension appliquée.

Les différentes premières étapes de réalisation d'un exemple de dispositif de l'invention sont illustrées en figure 3a à 3d, avant la croissance des nanotubes caractérisant les nano-commutateurs. Le composant RF de la présente invention est représenté en figure 3a sous la forme d'une ligne RF ou ligne signal Ls, deux flèches RFin et RFout sont relatives au signal d'entrée et au signal de sortie. Cette ligne signal est positionnée sur un substrat S₀ à la surface duquel est réalisée un dépôt de couche diélectrique isolante électriquement Cd, entre deux plans de masse M₁ et M₂. La ligne signal peut être connectée aux deux plans de masse M₁ et M₂ via deux nano-commutateurs NCc₁ et NCc₂.

La figure 3b illustre une vue agrandie des nano-commutateurs de la figure 3a. La ligne Ls présente deux bras latéraux L_{sb1} et L_{sb2}. Le plan de masse M₁ présente deux bras latéraux M_{b11} et M_{b12}, le plan de masse M₂ présente deux bras latéraux M_{b21} et M_{b22}. Le nano-commutateur NC_{C1} sera positionné en bout de bras L_{bs1} et entre les bras M_{b11} er M_{b12}. Le nano-commutateur NC_{c2} sera positionné en bout de bras L_{sb2} et entre les bras M_{b21} et M_{b22}.

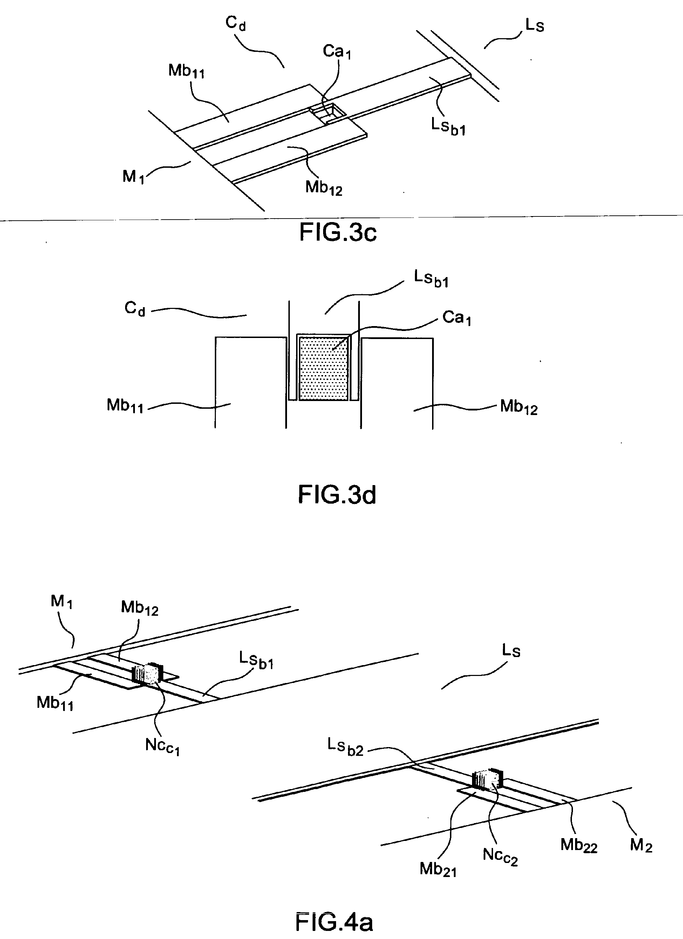

La figure 3c illustre la cavité Cₐ₁, réalisée dans la couche de diélectrique Cd, au niveau de l'extrémité du bras latéral L_{sb1} de la ligne Ls et ce avant les opérations de croissance des nanotubes, positionné au niveau des deux bras M_{b11} et M_{b12}.

La figure 3d est une vue agrandie de ladite cavité Cₐ₁.

La figure 4a illustre une vue d'ensemble des deux nano-commutateurs NC_{c1} et NC_{c2} au niveau des deux cavités réalisées pour y faire croître deux séries de nanotubes en contact direct avec le substrat.

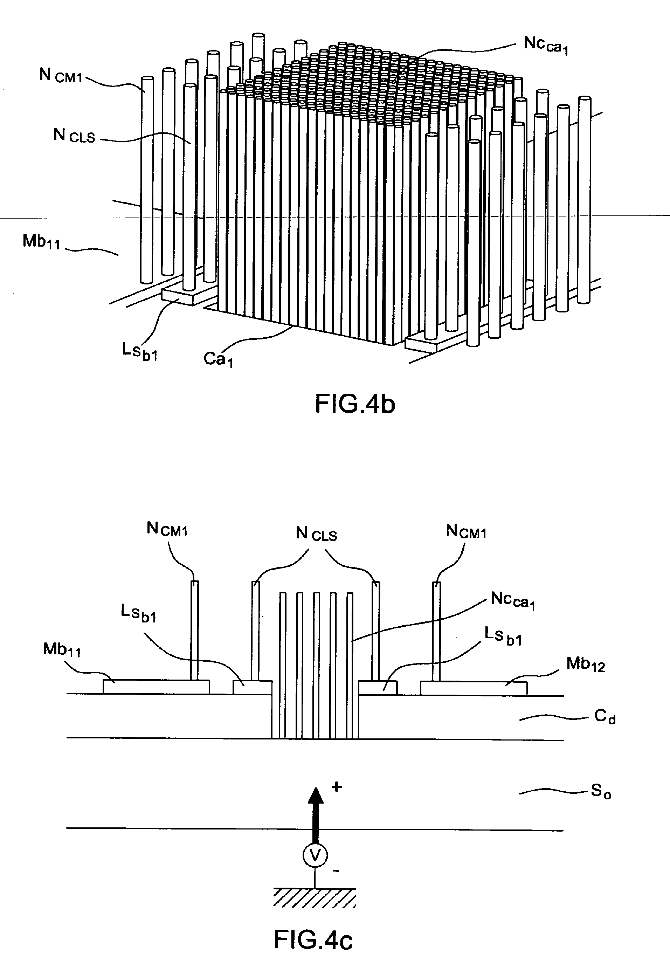

La figure 4b illustre une vue agrandie du nano-commutateur utilisé dans la présente invention. Il comporte ainsi une cavité Cₐ₁ réalisée dans la couche de diélectrique Cd, une première série de nanotubes Nc_{Ls}, réalisée en croissance à la surface du bras latéral L_{sb1} de la ligne Ls, une seconde série de nanotubes Nc_{M1} réalisée en croissance à la surface du bras latéral M_{b11} et une troisième série de nanotubes Nc_{ca1} réalisée en croissance directement dans la cavité Cₐ₁ en contact avec le substrat S₀.

La figure 4c, illustre une vue en coupe du nano-commutateur réalisé entre les deux bras M_{b11} et M_{b12}, comprenant la cavité Cₐ₁ réalisée dans le bras L_{sb1}.

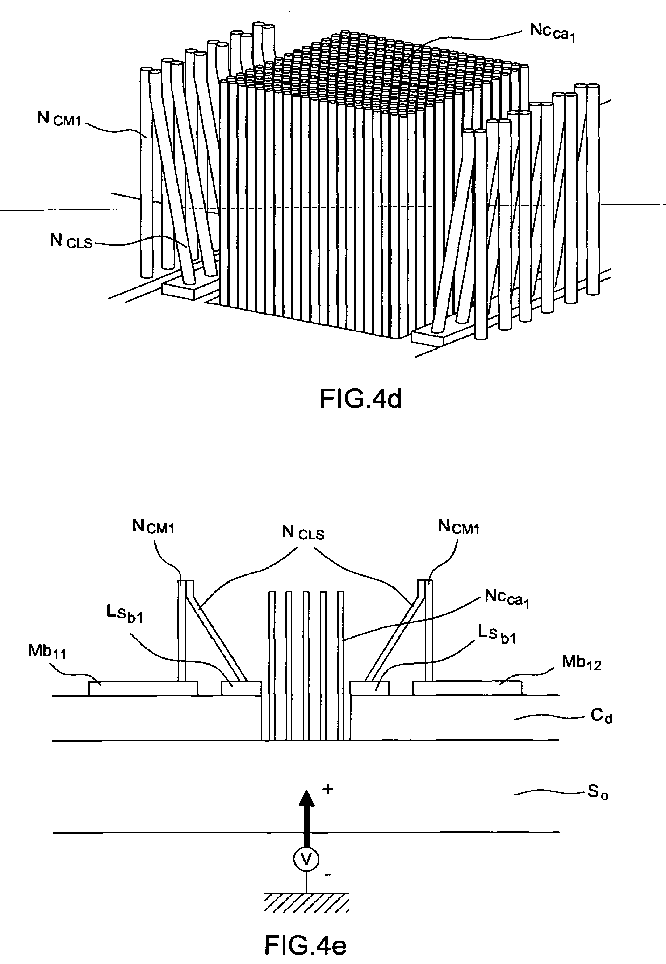

La figure 4d, illustre le nano-commutateur de la figure 4b, sous tension appliquée telle que représentée en figure 2c. Plus précisément l'activation de ce NEMS RF à contact ohmique nanotubes-nanotubes se fait en appliquant une très faible différence de potentiel entre la ligne et les plans de masse inférieure au volt afin de faire circuler un maximum de signal entre les nanotubes commutés sans risquer la destruction en puissance .

La troisième série de nanotubes Nc_{Ca1} est utilisée dans la cavité comme électrode d'activation par polarisation du substrat sous l'application d'une tension d'au moins une dizaine de volts.

La figure 4e illustre une vue en coupe du nano-commutateur réalisé entre les deux bras M_{b11} et M_{b12}, comprenant la cavité Cₐ₁ réalisée dans le bras L_{sb1}, telle que représentée en figure 2c.

Avantageusement, le substrat est un substrat en matériau conducteur pouvant être du silicium polarisé, la couche de diélectrique est en silice. L'épaisseur de la couche diélectrique peut typiquement être de l'ordre d'une centaine de nanomètres. Les nanotubes sont des nanotubes de carbone de type MWCNTs pour leurs propriétés métalliques.

De manière générale, les nanotubes de carbone sont des structures tubulaires très minces formées par un ou plusieurs feuillets de graphite enroulés sur eux-mêmes. Les nanotubes de carbone peuvent être produits à haute température supérieure à 1000 °C par l'application d'une décharge électrique entre deux électrodes de graphite ou à moyenne température inférieure à 1000 °C par PECVD (Plasma Enhanced Chemical Vapor Deposition). En général, les nanotubes de carbone sont classés en deux catégories : les nanotubes monofeuillets, ou SWCNT, composés d'une structure tubulaire formée d'un feuillet de graphite enroulé sur lui-même, et qui se distinguent des nanotubes multifeuillets ou MWCNT, qui peuvent être considérés comme formés de plusieurs nanotubes SWCNT concentriques.

Le champ électrostatique ainsi créé sur les nanotubes de carbone dans la cavité vient compenser le manque en tension entre les nanotubes de carbone et pousse les MWCNTs positionnés sur la ligne sur les MWCNTs positionnés sur les plans de masse. Ainsi à l'état « off » le signal hyperfréquence est passant de RFin à RFout et à l'état « on » le signal hyperfréquence est bloquant (court-circuité) de RFin au plan de masse.

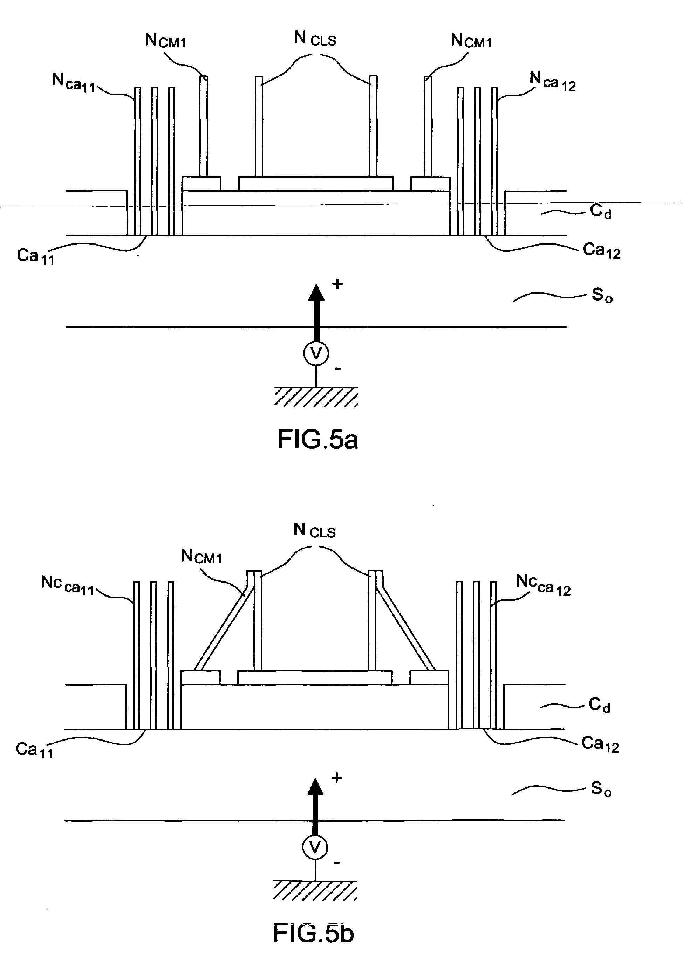

Selon une autre variante de l'invention illustrée en figures 5a.et 5b, le composant RF peut comprendre deux cavités Ca₁₁, et Ca₁₂, de part et d'autre du plan de masse M₁ via les bras Mb₁₁ et Mb₁₂.

La différence de potentiel est dans ce cas appliquée entre les nanotubes Nc_{Ls} et Nc_{M1} et le champ électrostatique issu de la polarisation du substrat vient pousser les nanotubes Nc_{M1} pour générer les contacts avec les nanotubes Nc_{Ls}.

Le composant RF comprend également de manière symétrique, deux autres cavités Ca₂₁ et Ca₂₂, de part et d'autre du plan de masse via les bras Mb₂₁ et Mb₂₂.

Selon une autre variante de l'invention, le composant RF peut comprendre des nano-commutateurs NEMS RF de type capacitifs. Ceux-ci nécessitent une étape technologique supplémentaire, qui consiste à recouvrir intégralement d'un diélectrique m_{d}, les MWCNTs se situant sur les plans de masse.

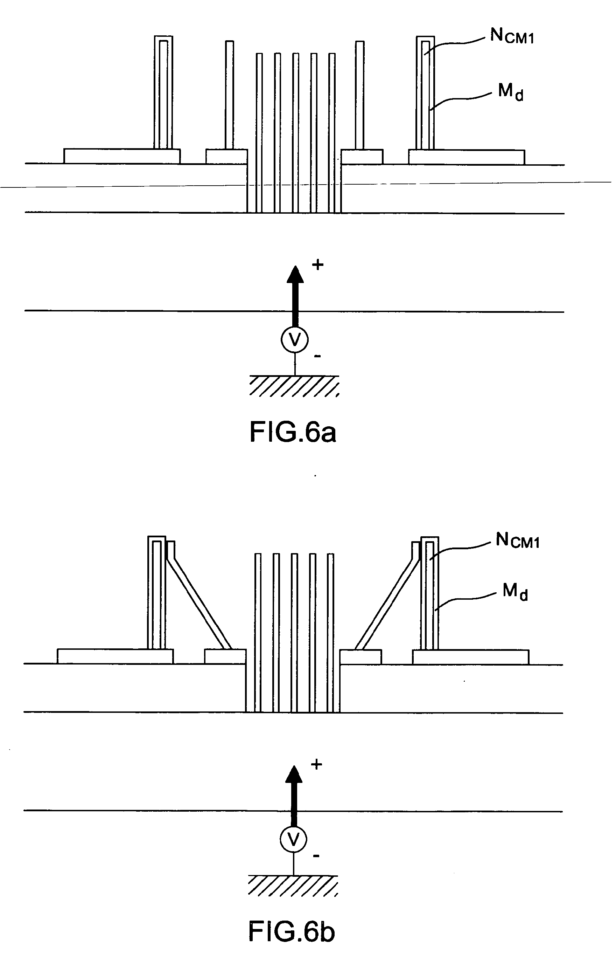

La figure 6a illustre ainsi une vue en coupe d'un nano-commutateur comportant des nanotubes enrobés de matériau diélectrique, sans tension appliquée, la figure 6b illustrant la même structure mise sous tension.

On peut par cette méthode aussi améliorer le contact ohmique du NEMS RF en recouvrant les MWCNTs se situant sur les plans de masse par une métallisation plus conductrice électriquement que les MWCNTs tel que le platine, le tungstène, l'or, etc....

Cette étape technologique utilise la FIB (Focussed Ion Beam) et plus spécifiquement le faisceau d'électron par la méthode dite EBID (Electron Beam Induced Deposition). Cette technique dissocie dans un gaz, l'espèce que l'on souhaite déposer et la propulse via le faisceau électronique sur le nanotube de carbone. Cette étape conduit à une augmentation du diamètre et de la longueur du MWCNT due au dépôt de matériau diélectrique ou métallique.

De ce fait il est établi, un contact capacitif ou une amélioration du contact ohmique, en commutation due à la présence du diélectrique ou d'un métal recouvrant les MWCNTs localisés sur les masses du guide coplanaire, par rapport à l'utilisation de nanotubes « nus ».

## Revendications

1. Composant RF comprenant au moins une ligne RF (Ls) coplanaire avec une surface métallique (M₁,M₂) à la surface d'un substrat (So) recouvert au moins partiellement d'une couche diélectrique (Cd) et une structure de commutateur située entre ladite ligne coplanaire et la surface métallique comprenant une première série de nanotubes ou nanofils (Nc_{Ls}) localisés verticalement à la surface de la ligne RF, une seconde série de nanotubes ou nanofils localisés (Nc_{M1}, Nc_{M2}) verticalement à la surface de ladite surface métallique permettant une activation de la structure de nano-commutateur (NC_{c1}, NC_{c2}) à contact nanotubes-nanotubes ou nanofils-nanofils entre ladite ligne RF et la surface métallique (M₁,M₂) par application d'une faible différence de potentiel entre la ligne RF et ladite surface métallique, **caractérisé en ce qu'**il comprend en outre une troisième série de nanotubes ou de nanofils (NC_{ca1}, Nc_{ca2}) localisée verticalement au niveau d'au moins une cavité (Cₐ₁, Cₐ₂, Cₐ₁₁, Cₐ₁₂, Cₐ₂₁, Cₐ₂₂) réalisée dans la couche de diélectrique et en contact avec la surface du substrat, ladite cavité étant située entre la ligne RF et ladite surface métalliques, ladite activation se faisant aussi avec une polarisation dudit substrat par une tension de polarisation.

2. Composant RF selon la revendication 1, **caractérisé en ce que** la faible différence de potentiel est inférieure à environ 1 Volt, la tension de polarisation du substrat étant supérieure à au moins une dizaine de volts.

3. Composant RF selon l'une des revendications 1 ou 2, **caractérisé en ce que** la ligne RF est située entre deux surfaces métalliques constitutives de plans de masse (M₁, M₂).

4. Composant RF selon l'une des revendications 1 à 3, **caractérisé en ce que** la ligne RF et la ou les surfaces métalliques sont parallèles entre elles selon une première direction, et comprennent des éléments latéraux (L_{sb1}, L_{sb2}, M_{b11}, M_{b12}, M_{b21}, M_{b22}) perpendiculaires à ladite première direction et coopérant entre eux via une commutation par l'intermédiaire des séries de nanotubes ou nanofils.

5. Composant RF selon la revendication 4, **caractérisé en ce que** les éléments latéraux de la ligne RF présentent chacun, une ouverture positionnée en regard d'une cavité dans laquelle est située la troisième série de nanotubes ou nanofils.

6. Composant RF selon l'une des revendications 1 à 5, **caractérisé en ce que** la première série ou la seconde série de nanotubes ou de nanofils comprend des nanotubes enrobés de matériau diélectrique (m_{d}).

7. Composant RF selon l'une des revendications 1 à 5, **caractérisé en ce que** la première série ou la seconde série de nanotubes est enrobée d'une couche de métal.

8. Composant RF selon l'une des revendications 1 à 7, **caractérisé en ce que** les dimensions des cavités sont de l'ordre de quelques micromètres.

9. Composant RF selon l'une des revendications 1 à 8, **caractérisé en ce que** la distance entre la ligne signal et les plans de masse est comprise entre environ 10 et 100 microns.

10. Composant RF selon l'une des revendications 1 à 9, **caractérisé en ce que** les cavités sont parallélépipédiques.

## Claims

1. An RF component comprising at least one RF line (Ls) that is coplanar with a metal surface (M₁, M₂) on the surface of a substrate (So) that is at least partially covered by a dielectric layer (Cd) and a switch structure, located between said coplanar line and said metal surface, comprising a first series of nanotubes or nanowires (Nc_{Ls}) vertically located on the surface of the RF line, a second series of nanotubes or nanowires (Nc_{M1}, Nc_{M2}) vertically located on the surface of said metal surface enabling activation of the nano-switch structure (NC_{c1}, NC_{c2}) with nanotube-nanotube or nanowire-nanowire contact between said RF line and said metal surface (M₁, M₂) by application of a low potential difference between the RF line and said metal surface, **characterised in that** it further comprises a third series of nanotubes or nanowires (Nc_{ca1}, Nc_{ca2}) vertically located at the level of at least one cavity (Cₐ₁, Cₐ₂,Cₐ₁₁, Cₐ₁₂, Cₐ₂₁, Cₐ₂₂) realised in the dielectric layer and in contact with the surface of the substrate, said cavity being located between the RF line and said metal surface, said activation also occurring with a polarisation of said substrate by a polarisation voltage.

2. The RF component according to claim 1, **characterised in that** the low potential difference is less than approximately 1 volt, the polarisation voltage of the substrate being greater than at least ten volts.

3. The RF component according to claim 1 or 2, **characterised in that** the RF line is located between two metal surfaces constituting ground planes (M₁, M₂).

4. The RF component according to any one of claims 1 to 3, **characterised in that** the RF line and the one or more metal surfaces are parallel with each other in a first direction, and include lateral elements (L_{sb1}, L_{sb2}, M_{b11}, M_{b12}, M_{b21}, M_{b22}) perpendicular to said first direction and co-operating together via a commutation by means of the series of nanotubes or nanowires.

5. The RF component according to claim 4, **characterised in that** the lateral elements of the RF line each have an opening positioned opposite a cavity in which the third series of nanotubes or nanowires is located.

6. The RF component according to any one of claims 1 to 5, **characterised in that** the first series or the second series of nanotubes or nanowires comprises nanotubes coated with dielectric material (m_{d}).

7. The RF component according to any one of claims 1 to 5, **characterised in that** the first series or the second series of nanotubes is coated with a metal layer.

8. The RF component according to any one of claims 1 to 7, **characterised in that** the dimensions of the cavities are of the order of a few micrometres.

9. The RF component according to any one of claims 1 to 8, **characterised in that** the distance between the signal line and the ground planes is between approximately 10 and 100 microns.

10. The RF component according to any one of claims 1 to 9, **characterised in that** the cavities are parallelopipedic.

## Patentansprüche

1. RF-Bauteil, umfassend mindestens eine koplanare RF-Leitung (Ls) mit einer metallischen Oberfläche (M₁, M₂) auf der Oberfläche eines Substrats (S₀), das mindestens teilweise mit einer dielektrischen Schicht (Cd) bedeckt ist und eine Schaltstruktur, die sich zwischen der koplanaren Leitung und der metallischen Oberfläche befindet, das eine erste Reihe Nanoröhren oder Nanodrähte (Nc_{LS}) umfasst, die vertikal auf der Oberfläche der RF-Leitung lokalisiert sind, wobei eine zweite Reihe Nanoröhren oder Nanodrähte (Nc_{M1}, Nc_{M2}), die vertikal auf der Oberfläche der metallischen Oberfläche lokalisiert sind, eine Aktivierung der Nano-Schaltstruktur (NC_{c1}, NC_{c2}) mit Nanoröhren-Nanoröhren- oder Nanodrähten-Nanodrähten-Kontakt zwischen der RF-Leitung und der metallischen Oberfläche (M₁, M₂) durch Anlegen einer schwachen Potentialdifferenz zwischen der RF-Leitung und der metallischen Oberfläche erlaubt, **dadurch gekennzeichnet, dass** es ferner eine dritte Reihe Nanoröhren oder Nanodrähte (Nc_{ca1}, Nc_{ca2}) umfasst, die vertikal auf Ebene mindestens einer Vertiefung (Cₐ₁, Cₐ₂, Cₐ₁₁, Cₐ₁₂, Cₐ₂₁, Cₐ₂₂) lokalisiert ist, die in der dielektrischen Schicht realisiert ist und im Kontakt mit der Oberfläche des Substrats, wobei sich die Vertiefung zwischen der RF-Leitung und der metallischen Oberfläche befindet, wobei die Aktivierung ebenfalls mit einer Polarisierung des Substrats durch eine Polarisationsspannung erfolgt.

2. RF-Bauteil nach Anspruch 1, **dadurch gekennzeichnet, dass** die schwache Potentialdifferenz kleiner ist als zirka 1 Volt, wobei die Polarisationsspannung des Substrats höher als mindestens etwa zehn Volt ist.

3. RF-Bauteil nach einem der Ansprüche 1 oder 2, **dadurch gekennzeichnet, dass** sich die RF-Leitung zwischen zwei metallischen Oberflächen befindet, die aus Masseebenen (M₁, M₂) bestehen.

4. RF-Bauteil nach einem der Ansprüche 1 bis 3, **dadurch gekennzeichnet, dass** die RF-Leitung und die metallische(n) Oberfläche(n) in einer ersten Richtung zueinander parallel sind und seitliche Elemente (L_{sb1}, L_{sb2}, M_{b11}, M_{b12}, M_{b21}, M_{b22}) senkrecht zur ersten Richtung umfassen, die miteinander über eine Kommunikation über Nanoröhren- oder Nanodrähte-Reihen zusammenarbeiten.

5. RF-Bauteil nach Anspruch 4, **dadurch gekennzeichnet, dass** die seitlichen Elemente der RF-Leitung jeweils eine Öffnung aufweisen, die gegenüber einer Vertiefung positioniert ist, in der sich die dritte Reihe Nanoröhren oder Nanodrähte befindet.

6. RF-Bauteil nach einem der Ansprüche 1 bis 5, **dadurch gekennzeichnet, dass** die erste Reihe oder die zweite Reihe Nanoröhren oder Nanodrähte Nanoröhren umfasst, die mit dielektrischem Material (m_{d}) ummantelt sind.

7. RF-Bauteil nach einem der Ansprüche 1 bis 5, **dadurch gekennzeichnet**, das die erste Reihe oder die zweite Reihe Nanoröhren mit einer Metallschicht ummantelt ist.

8. RF-Bauteil nach einem der Ansprüche 1 bis 7, **dadurch gekennzeichnet, dass** die Abmessungen der Vertiefungen die Größenordnung von einigen Mikrometern haben.

9. RF-Bauteil nach einem der Ansprüche 1 bis 8, **dadurch gekennzeichnet, dass** der Abstand zwischen der Signallinie und den Masseebenen zwischen zirka 10 und 100 Mikron inklusive ist.

10. RF-Bauteil nach einem der Ansprüche 1 bis 9, **dadurch gekennzeichnet, dass** die Vertiefungen parallelepipedisch sind.
